# EUROPEAN PATENT APPLICATION

(11) **EP 4 722 890 A1**
(43) Date of publication of application: **08.04.2026**
(21) Application number: 24815109.4
(22) Date of filing: 07.05.2024
(51) Int. Cl.: G06F 3/16, G05B 23/02, G06F 3/01, G10L 15/22, G10L 17/00, H01L 21/02, H01L 21/304

(54) **WORK ASSISTANCE METHOD AND WORK ASSISTANCE SYSTEM**

(30) Priority: 30.05.2023 JP 2023088650
(71) Applicant: SCREEN Holdings Co., Ltd., Kyoto-shi, Kyoto 602-8585 (JP)
(72) Inventor: SHIMIZU, Shinji, Kyoto-shi, Kyoto 602-8585 (JP)
(74) Representative: Kilian Kilian & Partner mbB
(86) International application number: PCT/JP2024/017005
(87) International publication number: WO 2024/247625

(57) **Abstract**

A worker performing a maintenance operation on a substrate processing apparatus wears a smart glass and emits operation instruction by voice. The smart glass receives the voice, converts the voice into a text by voice recognition, and displays the text. The worker visually confirms the displayed text, and expresses that a confirmation result is accepted by a hand gesture when contents thereof are correct. The smart glass takes an image of the gesture of the worker and analyzes the gesture, and generates and transmits a command of operation instruction to the substrate processing apparatus only when the confirmation result is accepted. Since the smart glass displays the contents converted into the text by voice recognition and the worker confirms the contents, an erroneous operation by a wrong voice recognition can be prevented.

## Description

### TECHNICAL FIELD

The present invention relates to a work assistance method and a work assistance system at a time of performing a predetermined operation such as a maintenance operation on an industrial apparatus such as a substrate processing apparatus performing predetermined processing on a substrate. Examples of a substrate to be processed by the substrate processing apparatus include a semiconductor substrate, a liquid crystal display apparatus substrate, a flat panel display (FPD) substate, an optical disk substrate, a magnetic disk substrate, or a solar cell substrate.

### BACKGROUND ART

A substrate processing apparatus performing various types of processing on a substate such as a semiconductor substrate is conventionally used in a step of manufacturing a semiconductor device. A substrate washing apparatus, a heat treatment apparatus, and an inspection apparatus, for example, are used as the substrate processing apparatus. Typically, a number of substrate processing apparatuses are systematically disposed in a large clean room in many cases. Maintenance is performed on these substrate processing apparatuses at an appropriate timing. Described in Patent Document 1 is that a number of substrate processing apparatuses are arranged with a relatively high density in a clean room and maintenance is performed on the substrate processing apparatuses.

Described in Patent Document 1 is that the substrate processing apparatus performs a maintenance operation (for example, an operation of discharging a processing solution from a processing solution nozzle) when a worker provides instruction of maintenance to the substrate processing apparatus. In a conventional typical maintenance operation, the worker manually performs an operation on each unit of the substrate processing apparatus using a remote controller in his/her hand. However, also recently performed is attempt that the worker wears a smart glass instead of having the remote controller and performs the maintenance operation. Considered is a system that the worker performs the operation using an operation panel displayed in the smart glass or by voice recognition or eye-tracking. Described in Patent Document 2 is that voice emitted from a worker is voice-recognized and displayed on a mobile terminal as text information.

### PRIOR ART DOCUMENTS

### PATENT DOCUMENT(S)

Patent Document 1: Japanese Patent Application Laid-Open No. 2020-4866
Patent Document 2: Japanese Patent Application Laid-Open No. 2021-83079

### SUMMARY

### PROBLEM TO BE SOLVED BY THE INVENTION

However, in the voice recognition, the smart glass wrongly translates contents of voice emitted from the worker in some cases. A plurality of processing units are normally mounted to one substrate processing apparatus, and a plurality of workers perform maintenance operation at the same time on one substrate processing apparatus. In such a case, there is a possibility that the smart glass may recognize voice of a person different from the worker wearing the smart glass. When the substrate processing apparatus performs an operation in accordance with such wrongly-recognized contents, the worker may face danger.

The present invention is therefore has been made to solve the above problems, and it is an object to provide a work assistance method and a work assistance system capable of preventing an erroneous operation by a wrong voice recognition.

### MEANS TO SOLVE THE PROBLEM

In order to solve the above problems, a first aspect of the present invention is a work assistance method in performing a predetermined operation on an industrial apparatus, including: a sound reception step of receiving operation instruction by voice emitted from a worker wearing a mobile terminal including a sound reception part, a display part, an imaging part, and a communication part by the sound reception part; a voice recognition step of analyzing voice of a worker received by the sound reception part and converting the voice into a text of the operation instruction; a display step of displaying the text of the operation instruction by the display part; a detection step of detecting a confirmation result indicated by a worker, who has confirmed the text of the operation instruction displayed by the display part, using a part of a body of the worker and obtaining confirmation information; an operation analyzing step of generating instruction information of the operation instruction when the confirmation information is analyzed and the confirmation result is accepted; and a transmission step of transmitting the instruction information of the operation instruction to the industrial apparatus by the communication part.

A second aspect is the work assistance method according to the first aspect, wherein in the detection step, the imaging part takes an image of a gesture of a worker.

A third aspect is the work assistance method according to the first or second aspect, wherein the mobile terminal further includes a visual line tracking part tracking a visual line of a worker wearing the mobile terminal, in the detection step, a portion of the industrial apparatus visually recognized by a worker is specified by the visual line tracking part, and in the operation analyzing step, it is determined that the confirmation result is accepted when a target portion as a target of the text of the operation instruction coincides with a portion visually recognized by a worker.

A fourth aspect is the work assistance method according to any one of the first to third aspects, wherein in the voice recognition step, voice analysis is executed only when a voice print of voice received by the sound reception part coincides with a voice print which is previously registered.

A fifth aspect is the work assistance method according to any one of the first to fourth aspects, wherein the voice recognition step includes: a phoneme specification step of specifying a phoneme included in voice of a worker received by the sound reception part using an acoustic model; and a word conversion step of converting an arrangement of the phoneme specified in the phoneme specification step into a word using a language model, and only a term relating to a specific operation on the industrial apparatus is registered in the language model.

A sixth aspect is the work assistance method according to any one of the first to fifth aspects, wherein the industrial apparatus is a substrate processing apparatus performing predetermined processing on a substrate.

A seventh aspect is the work assistance method according to any one of the first to sixth aspects, wherein the mobile terminal is a smart glass.

An eighth aspect is a work assistance system in performing a predetermined operation on an industrial apparatus using a mobile terminal, wherein the mobile terminal includes: a sound reception part receiving operation instruction by voice emitted from a worker wearing the mobile terminal; a voice recognition part analyzing voice of a worker received by the sound reception part and converting the voice into a text of the operation instruction; a display part displaying the text of the operation instruction; a detection part detecting a confirmation result indicated by a worker, who has confirmed the text of the operation instruction displayed, using a part of a body of the worker and obtaining confirmation information; an operation analyzing part analyzing the confirmation information and generating instruction information of the operation instruction when the confirmation result is accepted; and a communication part transmitting the instruction information of the operation instruction to the industrial apparatus.

A ninth aspect is the work assistance system according to the eighth aspect, wherein the detection part includes an imaging part taking an image of a gesture of a worker.

A tenth aspect is the work assistance system according to the eighth or ninth aspect, wherein the detection part includes a visual line tracking part tracking a visual line of a worker wearing the mobile terminal and specifying a portion of the industrial apparatus visually recognized by a worker, and the operation analyzing part determines that the confirmation result is accepted when a target portion as a target of the text of the operation instruction coincides with a portion visually recognized by a worker.

An eleventh aspect is the work assistance system according to any one of the eighth to tenth aspects, wherein the voice recognition part executes voice analysis only when a voice print of voice received by the sound reception part coincides with a voice print which is previously registered.

A twelfth aspect is the work assistance system according to any one of the eighth to eleventh aspects, wherein the voice recognition part specifies a phoneme included in voice of a worker received by the sound reception part using an acoustic model and converts an arrangement of the phoneme which has been specified into a word using a language model, and only a term relating to a specific operation on the industrial apparatus is registered in the language model.

A thirteenth aspect is the work assistance system according to any one of the eighth to twelfth aspects, wherein the industrial apparatus is a substrate processing apparatus performing predetermined processing on a substrate.

A fourteenth aspect is the work assistance system according to any one of the eighth to thirteenth aspects, wherein the mobile terminal is a smart glass.

### EFFECTS OF THE INVENTION

According to the work assistance method according to the first to seventh aspects, the operation instruction by the voice emitted from the worker wearing the mobile terminal is received, converted into the text, and displayed, and when the confirmation result of the worker confirming the text is accepted, the instruction information of the operation instruction is transmitted to the industrial apparatus. Thus, when the voice recognition is wrong, the operation instruction is not supplied to the industrial apparatus, and an erroneous operation by the wrong voice recognition can be prevented.

Specifically, according to the work assistance method in the fourth aspect, since the voice analysis is executed only when the voice print of the received voice coincides with the voice print which is previously registered, execution of the operation instruction by a person different from the registered worker can be prevented more reliably.

Specifically, according to the work assistance method according to the fifth aspect, since only the term relating to the specific operation on the industrial apparatus is registered in the language model, the operation instruction by the voice emitted from the worker can be converted into the text more precisely and accurately.

According to the work assistance system according to the eighth to fourteenth aspects, the operation instruction by the voice emitted from the worker wearing the mobile terminal is received, converted into the text, and displayed, and when the confirmation result of the worker confirming the text is accepted, the instruction information of the operation instruction is transmitted to the industrial apparatus. Thus, when the voice recognition is wrong, the operation instruction is not supplied to the industrial apparatus, and an erroneous operation by the wrong voice recognition can be prevented.

Specifically, according to the work assistance system in the eleventh aspect, since the voice analysis is executed only when the voice print of the received voice coincides with the voice print which is previously registered, execution of the operation instruction by a person different from the registered worker can be prevented more reliably.

Specifically, according to the work assistance system according to the twelfth aspect, since only the term relating to the specific operation on the industrial apparatus is registered in the language model, the operation instruction by the voice emitted from the worker can be converted into the text more precisely and accurately.

### BRIEF DESCRIPTION OF DRAWINGS

[Fig. 1] is a diagram schematically illustrating a schematic configuration of a work assistance system according to the present invention.
[Fig. 2] is a plan view for explaining a layout inside a substrate processing apparatus.
[Fig. 3] is a plan view illustrating a schematic configuration of a processing unit.
[Fig. 4] is a side view illustrating the schematic configuration of the processing unit.
[Fig. 5] is a perspective view illustrating an appearance of a smart glass.
[Fig. 6] is a block diagram illustrating a functional configuration of a controller of the smart glass, a server, a work assistance terminal, and the substrate processing apparatus.
[Fig. 7] is a flow chart illustrating a procedure of a work assistance method according to the present invention.
[Fig. 8] is a diagram schematically illustrating a voice recognition process by a voice recognition part.
[Fig. 9] is a diagram illustrating an example of display of a text by the smart glass.
[Fig. 10] is a diagram illustrating an example of a gesture of a worker whose image is taken by an imaging part.

### DESCRIPTION OF EMBODIMENT(S)

Embodiments according to the present invention will now be described in detail with reference to the diagrams. In the description hereinafter, unless otherwise noted, the expressions indicating relative or absolute positional relationships (e.g., "in one direction", "along one direction", "parallel", "orthogonal", "central", "concentric", and "coaxial") include those exactly indicating the positional relationships and those where an angle or a distance is relatively changed within tolerance or to the extent that similar functions can be obtained. Unless otherwise noted, the expressions indicating equality (e.g., "same", "equal", and "uniform") include those indicating quantitatively exact equality and those in the presence of a difference within tolerance or to the extent that similar functions can be obtained. Unless otherwise noted, the expressions indicating shapes (e.g., "circular", "rectangular", and "cylindrical") include those indicating geometrically exact shapes and those indicating, for example, roughness or a chamfer to the extent that similar effect can be obtained. An expression "comprising", "including", or "having" a certain constituent element is not an exclusive expression for excluding the presence of the other constituent elements. An expression "at least one of A, B, and C" involves "only A", "only B", "only C", "arbitrary two of A, B, and C", and "all of A, B, and C".

### <First embodiment>

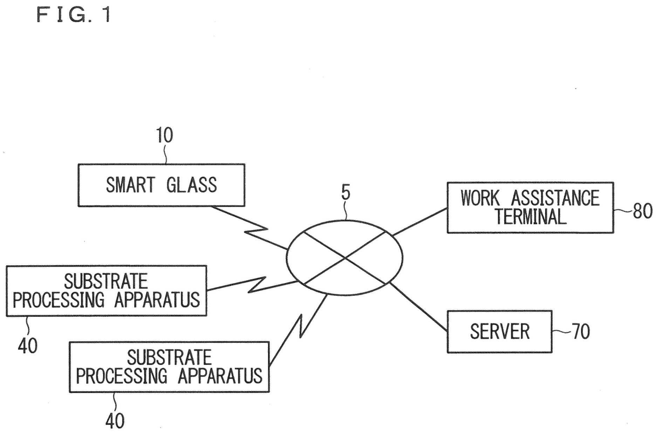

Fig. 1 is a diagram schematically illustrating a schematic configuration of a work assistance system according to the present invention. The work assistance system according to the present invention includes a plurality of substrate processing apparatuses 40, a smart glass 10, a server 70, and a work assistance terminal 80. Controllers of the smart glass 10 and the substrate processing apparatus 40 are connected to an information communication network 5 (for example, Internet) via wireless communication. The work assistance terminal 80 and the server 70 are connected to the information communication network 5 by wire. Information can be mutually transmitted and received between apparatuses connected to the information communication network 5, and information can be provided and received between the smart glass 10 and the work assistance terminal 80, for example. Whether each apparatus and the information communication network 5 are connected wirelessly or by wire is not limited to the above example. However, an appropriate configuration is applicable (for example, the work assistance terminal 80 and the information communication network 5 may be wirelessly connected.)

The plurality of substrate processing apparatuses 40 are disposed side by side in a clean room, for example. The clean room is provided in a manufacturing plant of a semiconductor device, for example, and is a room in which constant air cleanliness is ensured and a temperature and humidity are managed. A worker performs an operation on the substrate processing apparatus 40 in the clean room.

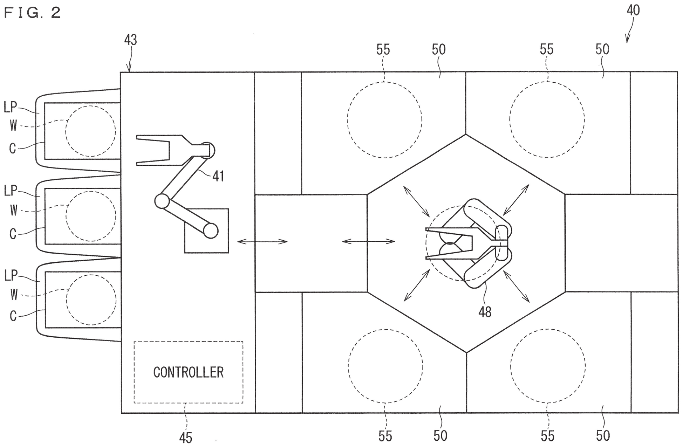

Fig. 2 is a plan view for explaining a layout inside the substrate processing apparatus 40. The substrate processing apparatus 40 is a single substrate washing apparatus processing a substate W as a disk-like silicon substrate such as a semiconductor wafer one by one. The substrate processing apparatus 40 includes an indexer 43, a plurality of processing units 50, a main transport robot 48, and a controller 45.

The indexer 43 includes a plurality of (three in the present embodiment) load ports LP and indexer robots 41. A carrier C housing the plural substrates W processed in the processing unit 50 is disposed in each load port LP. A form of the carrier C may be a front opening unified pod (FOUP) housing the semiconductor wafer W in an enclosed space, and, in addition, a standard mechanical interface (SMIF) pod or an open cassette (OC) exposing the housed semiconductor wafer W to outdoor air.

The indexer robot 41 transports the substate W between the carrier C and the main transport robot 48. The indexer robot 41 is a multi-joint robot, for example, and can provide and receive the substrate W for any carrier C disposed in the plurality of load ports LP.

The main transport robot 48 transports the substate W between the indexer robot 41 and the processing unit 50. The main transport robot 48 is configured to be able to perform an elevating movement, a pivot movement, and an advancing/retracting movement of a transport arm. The main transport robot 48 receives the unprocessed substrate W taken out from the carrier C by the indexer robot 41 and transports the substrate W into the processing unit 50. The indexer robot 41 receives the substrate W which has been processed and transported from the processing unit 50 by the main transport robot 48 and houses the substrate W in the carrier C.

In the substrate processing apparatus 40, three processing units 50 are stacked to constitute one laminated body, for example. Four laminated bodies are disposed around the main transport robot 48, for example. That is to say, one substrate processing apparatus 40 includes twelve (= 3×4) processing units 50, for example. Fig. 2 schematically illustrates one of the processing units 50 stacked in three tiers. The number of the processing units 50 in the substrate processing apparatus 40 is not limited to 12, but may appropriately be changed.

The main transport robot 48 is disposed in a center of four laminated bodies made up of the stacked processing units 50. The main transport robot 48 transports the substrate W to be processed received from the indexer robot 41 into a cup 55 of any of the processing units 50. The main transport robot 48 transports the substate W which has been processed from each processing unit 50 and passes the substate W to the indexer robot 41.

The substrate processing apparatus 40 includes a controller 45. The controller 45 is a general computer, and controls an operation of the indexer robot 41, the main transport robot 48 disposed in the apparatus, and mechanisms provided to each processing unit 50. The controller 45 includes a touch panel as an input-output interface provided to a wall surface of the apparatus and a communication part having communication with an outer part of the apparatus. Although Fig. 2 illustrates the controller 45 in the indexer 43 for convenience of illustration, the configuration is not limited thereto. The controller 45 is provided to an appropriate position in the substrate processing apparatus 40.

One of twelve processing units 50 mounted to the substrate processing apparatus 40 is described hereinafter. The other processing unit 50 has a similar configuration except that an arrangement relationship of the nozzle is different.

The processing unit 50 discharges a processing solution to one substrate W to perform washing processing. The processing solution is a conceptual term including various types of chemical solutions and pure water. Examples of the chemical solution include a solution for performing etching processing or a solution for removing particles, and applied specifically is an SC-1 solution (a mixed solution of ammonium hydroxide, hydrogen peroxide water, and pure water), an SC-2 solution (a mixed solution of hydrochloric acid, hydrogen peroxide water, and pure water), or hydrofluoric acid, for example.

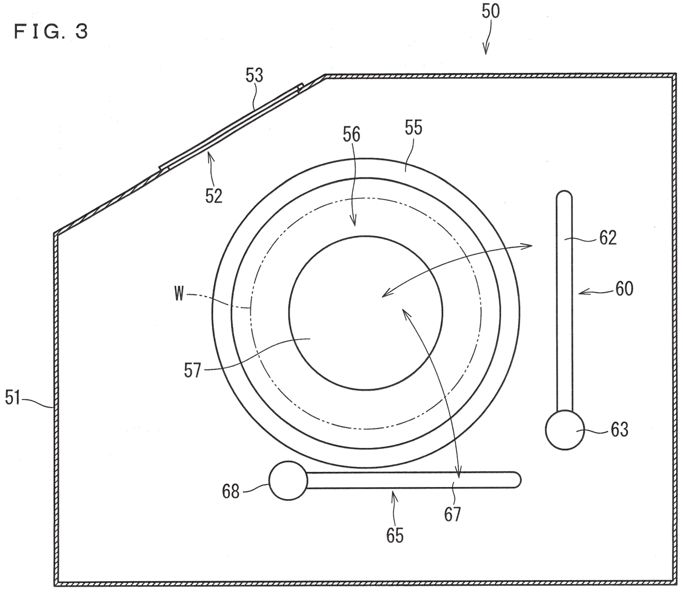

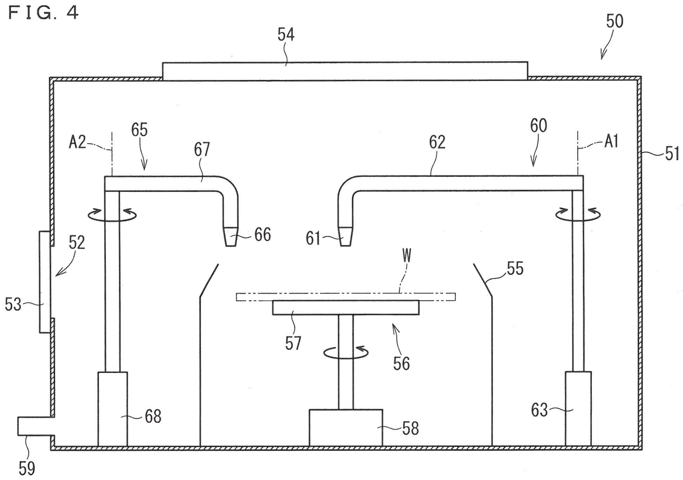

Fig. 3 is a plan view illustrating a schematic configuration of the processing unit 50. Fig. 4 is a side view illustrating a schematic configuration of the processing unit 50. The processing unit 50 includes a processing chamber 51, a rotation holder 56, a processing solution nozzle (first nozzle) 60, a spray nozzle (second nozzle) 65, and the cup 55. The processing chamber 51 is a hollow chassis. The rotation holder 56, the processing solution nozzle 60, the spray nozzle 65, and the cup 55, for example, are provided inside the processing chamber 51.

A transfer port 52 is provided to a sidewall of the processing chamber 51. The transfer port 52 is opened and closed by a shutter 53. The main transport robot 48 transports the substrate W into and out of the processing chamber 52 from the transfer port 52 while the shutter 53 opens the transfer port 52. The shutter 53 closes the transfer port 52 during processing on the substrate W. When the shutter 53 closes the transfer port 52, a semi-enclosed space is made in the processing chamber 51.

A fan filter unit (FFU) 54 is provided to a ceiling part of the processing chamber 51. The FFU 54 supplies clean air from the ceiling part of the processing chamber 51 toward inside the processing chamber 51. Accordingly, a downflow of the clean air from an upper side toward a lower side is formed in the processing chamber 51. The air supplied inside the processing chamber 51 is discharged from an exhaust duct 59 provided in a bottom part of the processing chamber 51.

The rotation holder 56 includes a spin chuck 57 and a spin motor 58. The spin chuck 57 is a substrate holder holding the substrate W in a horizontal posture (posture in which a normal line of a main surface of the substrate W follows a vertical direction). The spin chuck 57 is a vacuum suction chuck, for example. The spin chuck 57 sucks and holds a center part of a lower surface of the substrate W. The spin chuck 57 may be a chuck of the other form such as a sandwiching-type mechanical chuck grasping an end edge portion of the substrate W.

The spin chuck 57 has a disk-like shape with a diameter smaller than the substrate W. In a state where the lower surface of the substrate W is sucked and held by the spin chuck 57, the peripheral edge portion of the substrate W protrudes to an outer side than an outer surrounding end of the spin chuck 57.

The spin chuck 57 is connected to the spin motor 58 via a motor shaft. That is to say, an upper end of the motor shaft of the spin motor 58 is connected to a center part of the lower surface of the spin chuck 57. When the spin motor 58 rotates the motor shaft while the substrate W is sucked and held by the spin chuck 57, the substrate W and the spin chuck 57 are rotated in a horizontal plane around a central axis along the vertical direction.

A cup 55 is provided to surround the spin chuck 57. The cup 55 can be moved up and down by an elevating mechanism not shown in the diagrams. The cup 55 has substantially a cylindrical shape, and an upper portion of the cup 55 is inclined to get closer to the spin chuck 57 toward the upper side. However, an inner diameter of an upper end portion of the cup 55 is larger than the diameter of the substrate W. In processing the substrate W, the upper end of the cup 55 is located in a higher position than a height position of the substrate W held by the spin chuck 57. Accordingly, a liquid flying in all directions from the substrate W rotated by the rotation holder 56 by centrifugal force during the processing is received by the cup 55 and collected. The liquid collected by the cup 55 is discharged from a discharge solution pipe not shown in the diagrams but provided to a bottom part of the cup 55. The cup 55 may have a multi-stage structure that a plurality of collection ports are provided for various purposes.

The processing solution nozzle 60 includes a nozzle distal end portion 61, a swing arm 62, and a swing motor 63. The processing solution nozzle 60 is a straight nozzle discharging the processing solution in a continuous flow state, for example. The nozzle distal end portion 61 is attached to a distal end of the swing arm 62 extending in substantially a horizontal direction. The processing solution is supplied to the nozzle distal end portion 61 from a processing solution supply source located out of the diagrams, a discharge port not shown in the diagram is formed in the nozzle distal end portion 61, and the processing solution is discharged from the discharge port. The swing arm 62 is swung in a horizontal plane around a swing axis A1 along a vertical direction by the swing motor 63. The swing motor 63 is a pulse motor, for example.

When the swing motor 63 swings the swing arm 62, the nozzle distal end portion 61 is moved along an arc-like trajectory between a processing position above the substrate W held by the rotation holder 56 and a standby position on an outer side than the cup 55. When the nozzle distal end portion 61 is located in the processing position, the processing solution nozzle 60 discharges a chemical solution to the substrate W held by the rotation holder 56 to proceed washing processing on the substrate W, for example. When the processing solution nozzle 60 discharges pure water to the substrate W, pure water rinsing processing on the substrate W proceeds. An encoder for detecting a position of the nozzle distal end portion 61 may be provided to the swing motor 63.

In the meanwhile, the spray nozzle 65 includes a nozzle distal end portion 66, a swing arm 67, and a swing motor 68. The splay nozzle 65 is a two-fluid nozzle mixing a processing solution with pressurized gas to generate a liquid drop and spraying a mixed fluid of the liquid drop and gas to the substrate W. The nozzle distal end portion 66 is attached to a distal end of the swing arm 67 extending in substantially a horizontal direction. A processing solution and pressurized gas are supplied from a processing solution supply solution and an gas supply source located out of the diagrams to the nozzle distal end portion 66, and are mixed in an inner portion or an outer portion of the nozzle distal end portion 61 to form a mixed fluid. The swing arm 67 is swung in a horizontal plane around a swing axis A2 along a vertical direction by the swing motor 68. The swing motor 68 is a pulse motor, for example.

When the swing motor 68 swings the swing arm 67, the nozzle distal end portion 66 is moved along an arc-like trajectory between a processing position above the substrate W held by the rotation holder 56 and a standby position on an outer side than the cup 55. When the nozzle distal end portion 66 is located in the processing position, the spray nozzle 65 discharges a mixed fluid to the substrate W held by the rotation holder 56 to proceed washing processing on the substrate W, for example. An encoder for detecting a position of the nozzle distal end portion 66 may be provided to the swing motor 68.

As illustrated in Fig. 3, a rotation operation of the processing solution nozzle 60 and a rotation operation of the spray nozzle 65 may interfere with each other. That is to say, there is a possibility that when the spray nozzle 65 is also moved to the upper side of the substrate W while the processing solution nozzle 60 is located in the processing position, they collide with each other. Thus, when any one of the processing solution nozzle 60 or the spray nozzle 65 is located in the processing position, an interlock is provided so that the other one thereof cannot be operated.

A worker performing an operation on the substrate processing apparatus 40 wears the smart glass 10. The smart glass 10 is a type of a wearable terminal of a head mount display (HMD) system. The smart glass 10 is also a device for achieving augmented reality (AR) or mixed reality (MR). HoloLens (registered trademark) manufactured by Microsoft Corporation, for example, can be used as the smart glass 10.

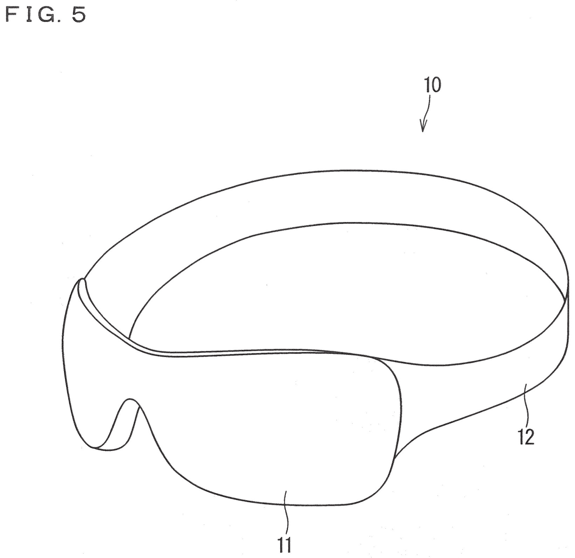

Fig. 5 is a perspective view illustrating an appearance of the smart glass 10. The smart glass 10 includes a visor 11 and a headband 12. A worker puts the headband 12 on a head to wear the smart glass 10. The worker can adjust a length of the headband 12 in accordance with a size of his/her head. A power source button, a light button, and a volume button, for example, are provided to the headband 12.

The visor 11 includes various sensors and a display. The display is a see-through holographic lens. That is to say, the display can display a three-dimensional vision on a visual space of the worker by a hologram, and light from an actual object passes through the display in the manner similar to a normal eyeglass lens. Accordingly, the worker wearing the smart glass 10 can also see a displayed three-dimensional vision while visually recognizing an actual object through the display.

Examples of the sensor of the visor 11 include a plurality of visible light cameras mainly taking an image in front of the visor 11, an infrared camera tracking a visual line of the worker, a depth sensor measuring a distance to a target object, and an inertial measurement sensor. The infrared camera measures a movement of eyeballs of a wearer of the smart glass 10 and tracks the visual line. The depth sensor measures a distance to a target object by a time of flight (ToF) system, for example. The inertial measurement sensor is made up of an accelerometer, a gyroscope, and a magnetometer, for example.

The smart glass 10 includes a built-in computer including a CPU, a memory, and a storage part, for example. A wireless communication mechanism is also provided to the smart glass 10, and the computer of the smart glass 10 is connected to the information communication network 5 using the wireless communication mechanism. Furthermore, a microphone, a speaker, and a battery, for example, are also provided to the smart glass 10.

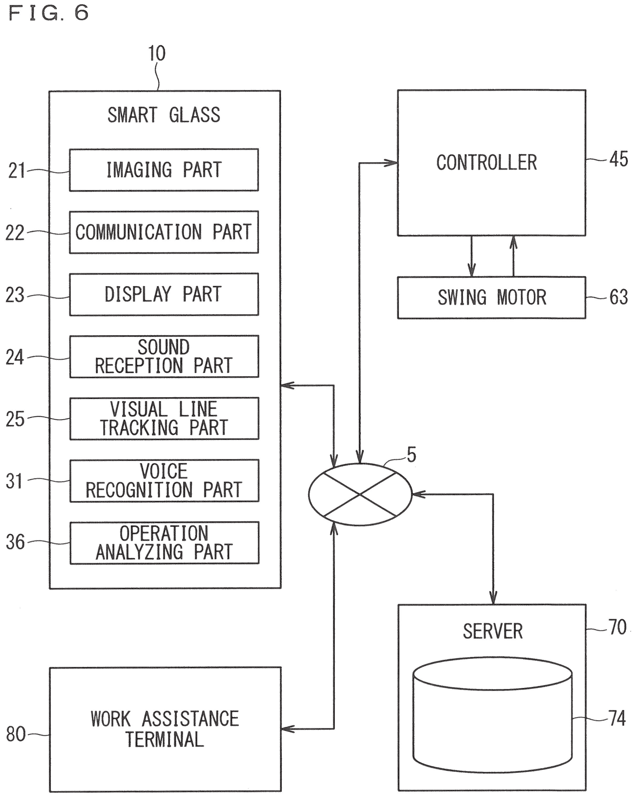

Fig. 6 is a block diagram illustrating a functional configuration of the smart glass 10, the server 70, the work assistance terminal 80, and the controller 45 of the substrate processing apparatus 40. The smart glass 10 includes an imaging part 21, a communication part 22, a display part 23, a sound reception part 24, and a visual line tracking part 25. The imaging part 21 includes a visible light camera provided to the visor 11 described above. The imaging part 21 includes four visible light cameras taking images of a front side and an obliquely front side, for example, and can take the image of a visual field range of the worker wearing the smart glass 10.

The communication part 22 includes the wireless communication mechanism of the smart glass 10 described above. The communication part 22 transmits and receives data to and from the work assistance terminal 80 and the server 70 via the information communication network 5. The communication part 22 can also directly transmit and receive the data to and from the controller 45 of the substrate processing apparatus 40 when they are located in a short distance. That is to say, the communication part 22 can transmit data or a command to the controller 45 of the substrate processing apparatus 40 directly or via the information communication network 5.

The display part 23 includes a display of the visor 11 described above. The display part 23 includes a holographic processing device, and displays a three-dimensional vision in a predetermined spatial position by a hologram technique. The three-dimensional vision displayed by the display part 23 is not limited to video having a three-dimensional shape. A two-dimensional video such as a document is also applicable.

The sound reception part 24 includes a microphone of the smart glass 10 described above. The sound reception part 24 converts sound reaching the smart glass 10 into an electrical signal. Thus, the sound reception part 24 can collect voice emitted from the worker wearing the smart glass 10 and convert the voice into the electrical signal. The electrical signal outputted from the sound reception part 24 may be housed in a storage part of the smart glass 10 (that is to say, the voice may be recorded).

The visual line tracking part 25 includes two infrared cameras measuring a movements of eyeballs of the worker. The visual line tracking part 25 has an eye-tracking function of tracking a visual line of the worker using two infrared cameras. The worker wearing the smart glass 10 can also perform an operation by a visual line using an eye-tracking function.

The smart glass 10 includes a voice recognition part 31 and an operation analyzing part 36. These voice recognition part 31 and the operation analyzing part 36 are function processing parts achieved by a CPU the smart glass 10 executing a predetermined processing program. Processing details of the voice recognition part 31 and the operation analyzing part 36 will be described in more detail below.

The controller 45 of the substrate processing apparatus 40 controls an operation of a mechanism provided to the processing unit 50 such as the swing motor 63. The controller 45 of the substrate processing apparatus 40 can have communication with the communication part 22 of the smart glass 10, and can also control operations of various mechanisms provided to the processing unit 50 in accordance with a command of the operation instruction transmitted from the smart glass 10.

The work assistance terminal 80 and the server 70 are disposed in a plant of a vendor manufacturing the substrate processing apparatus 40 and undertaking a maintenance check, for example. The work assistance terminal 80 and the server 70 can have communication with the smart glass 10 via the information communication network 5. The work assistance terminal 80 and the server 70 can also have mutual communication with each other via the information communication network 5.

The work assistance terminal 80 and the server 70 are general computer systems. That is to say, the work assistance terminal 80 and the server 70 include a CPU that is a circuit for performing various types of computation processing, a ROM or read-only memory for storing a basic program therein, a RAM or readable/writable memory for storing various types of information therein, a storage part (for example, a magnetic disk or an SSD) for storing control software, data and the like therein, and a communication part having communication with the information communication network 5.

The work assistance terminal 80 is a computer for a work assistant on a vendor side to assist an operation of a worker in the clean room. The work assistant can transmit various types of information from the work assistance terminal 80 to the smart glass 10 which the worker in the clean room wears.

The server 70 is a computer executing predetermined processing in accordance with request from the smart glass 10 and the work assistance terminal 80 in the work assistance system according to the present invention. The server 70 includes a storage part 74 having relatively large capacity. Large size data created by the smart glass 10 and the work assistance terminal 80 may be stored in the storage part 74. The server 70 and the operation assistance terminal 80 are not necessary elements.

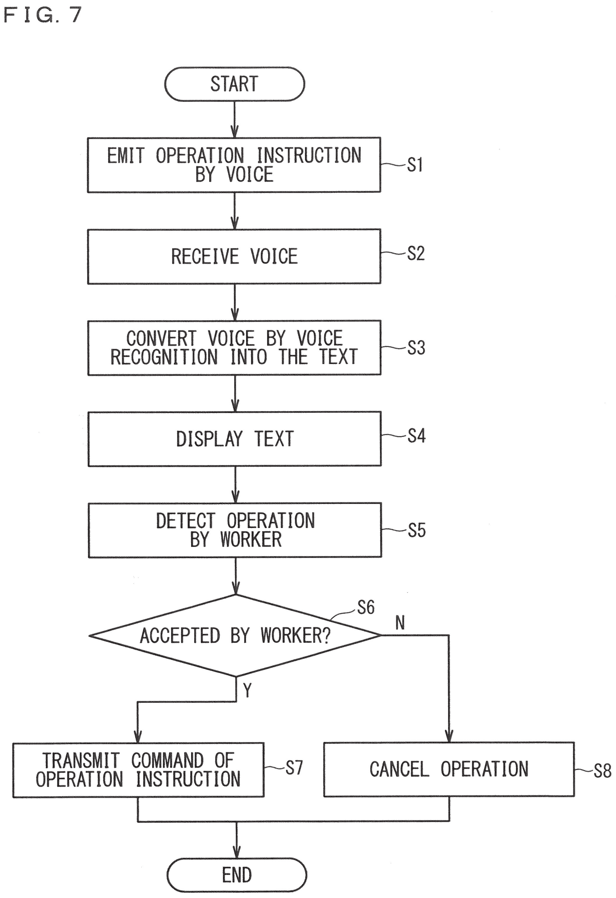

A work assistance method using the work assistance system having the above configuration is described next. Fig. 7 is a flow chart illustrating a procedure of the work assistance method according to the present invention. A worker wearing the smart glass 10 performs a maintenance operation on the substrate processing apparatus 40 in the present embodiment. Examples of items of the specific maintenance operation on the substrate processing apparatus 40 include teaching of a processing position on the processing solution nozzle 60, exchange of the spin chuck 57, and teaching on the arm of the main transport robot 48. The worker does not perform the operation with a remote controller in his/her hand in a conventional manner, but performs the operation on each unit of the substrate processing apparatus 40 using the smart glass 10. Particularly, the worker performs the operation by voice in the present embodiment.

Firstly, the worker wearing the smart glass 10 emits operation instruction by voice (Step S1). For example, when teaching is performed on the processing solution nozzle 60, the worker emits the voice of "inching plus 8 pixels". For example, when adjustment is performed after exchanging the spin chuck 57, the worker emits voice of "chuck open".

The voice emitted from the worker is received the sound reception part 24 of the smart glass 10 (Step S2). The received voice is converted into an electrical signal by the sound reception part 24.

Next, the voice received by the sound reception part 24 is converted into a text by voice recognition by the voice recognition part 31 (Step S3). The voice recognition part 31 analyzes the voice of the worker received by the sound reception part 24 and converts the voice into the text of the operation instruction.

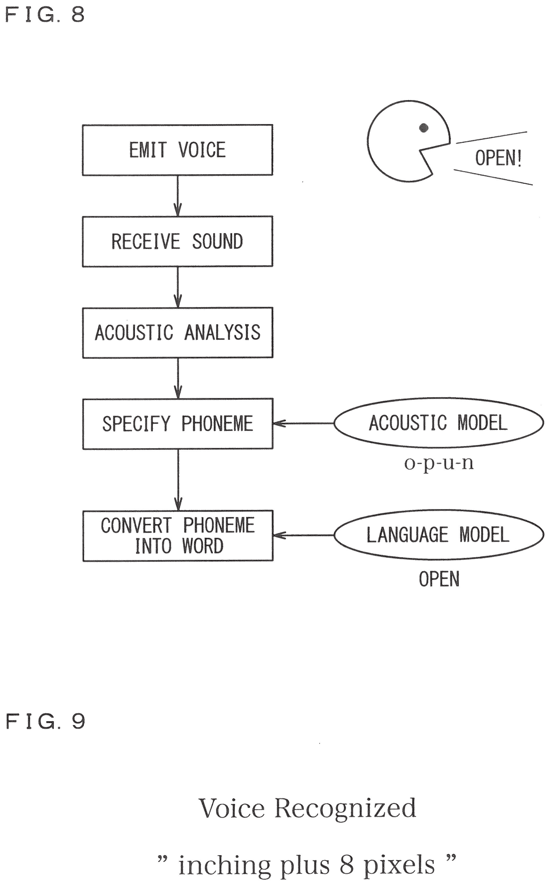

Fig. 8 is a diagram schematically illustrating a voice recognition process by the voice recognition part 31. The voice emitted from the worker is received by the sound reception part 24 and converted into the electrical signal. Furthermore, a feature amount is extracted from the voice signal, and the voice signal is converted into voice data easily recognized by a computer (acoustic analysis). Although a human can even read voice with a little noise, it may be difficult for the computer to recognize the voice as it is. Thus, the voice data is processed so that the computer easily recognizes the voice.

Next, the voice recognition part 31 specifies a phoneme from the voice data. The phoneme is a minimum unit of vocal sound. The voice recognition part 31 specifies the phoneme included in the voice of the worker received by the sound reception part 24 using the acoustic model. The acoustic model is a module checking a feature of the voice signal extracted by the acoustic analysis described above from previously-learned data to extract a phoneme closest to the inputted voice. For example, as illustrated in Fig. 8, when the worker emits voice of "open", the voice recognition part 31 specifies a phoneme (phoneme row) included in the voice of the worker as "o-pe-n" using the acoustic model.

Since the phoneme row specified using the acoustic model is only a series of phonemes, the voice recognition part 31 converts the specified arrangement of the phonemes into a word having a meaning using a language model. The language model is a module extracting a word having a highest possibility of appearance from the specified phonemes based on the word information which has been previously stored and outputting the word. For example, when the arrangement of the phonemes illustrated in Fig. 8 is specified, the voice recognition part 31 specifies, using the language model, that the voice emitted from the worker is a word of "OPEN". When the arrangement of the phonemes are converted into the word, a voice dictionary in which word information including words, which have been previously stored, are registered may be used in addition to the language model.

The voice of the worker is converted into the text through the voice recognition process described above. Returning to Fig. 7, the display part 23 of the smart glass 10 displays the text of the obtained operation instruction (Step S4). Fig. 9 is a diagram illustrating an example of display of the text by the smart glass 10. The display part 23 of the smart glass 10 displays the text of the operation information obtained by the voice recognition as a three-dimensional vision. In the example in Fig. 9, "inching plus 8 pixels" obtained by analyzing the voice of the worker is displayed as the three-dimensional vision.

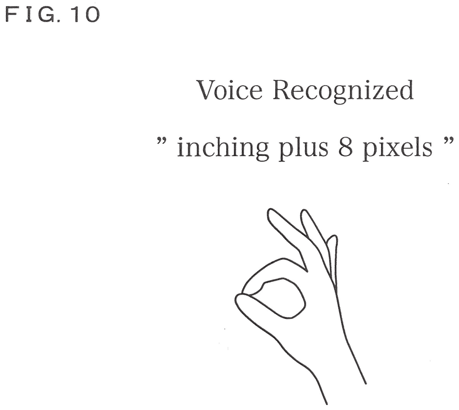

The worker wearing the smart glass 10 visually confirms the displayed text of the operation instruction. Then, in the first embodiment, the worker expresses whether or not the confirmation result is accepted, that is to say, whether or not the displayed text corresponds to the voice by a gesture of a hand (or a finger action), for example. An image of the gesture indicated by the worker is taken by the imaging unit 21 of the smart glass 10, and is detected (Step S5). That is to say, in the first embodiment, the imaging unit 21 functions as a detection part detecting the confirmation result indicated by the worker and obtaining the confirmation information (gesture). Fig. 10 is a diagram illustrating an example of the gesture of the worker whose image is taken by the imaging part 21.

Next, the operation analyzing part 36 of the smart glass 10 analyzes the obtained confirmation information and determines whether or not the confirmation result is accepted. In the first embodiment, the operation analyzing part 36 analyzes the gesture of the worker whose image is taken by the imaging unit 21 and determines whether or not the displayed text is correct. Specifically, it is applicable to constitute a model with learned data of images of a large number of hand gestures taken for both cases where the confirmation result is accepted and denied and make determination whether or not the confirmation result is accepted using the model.

For example, a gesture of making a circle with a thumb and an index finger illustrated in Fig. 10 is a gesture indicating that the confirmation result is accepted. The operation analyzing part 36 determines that the confirmation result is accepted, that is to say, the worker accepts the displayed text when the operation analyzing part 36 analyzes the gesture illustrated in Fig. 10. In this case, the process proceeds from Step S6 to Step S7, and the smart glass 10 generates a command of the operation instruction corresponding to the text of the operation instruction obtained by the voice recognition. Then, the communication part 22 of the smart glass 10 transmits the command of the operation instruction to the controller 45 of the substrate processing apparatus 40. In the example described above, the command of the operation instruction having contents of "inching plus 8 pixels" is transmitted from the smart glass 10 to the controller 45 of the substrate processing apparatus 40.

Upon receiving the command of the operation instruction from the smart glass 10, the controller 45 executes the command. For example, when the command having the above contents is received, the controller 45 moves the swing motor 63 by 8 pixels to inch the processing solution nozzle 60.

In the meanwhile, a gesture of making a cross mark with index fingers of right and left hands is a gesture indicating that the confirmation result is denied. The operation analyzing part 36 determines that the confirmation result is denied, that is to say, the worker does not accept the displayed text when the operation analyzing part 36 analyzes such a gesture. In this case, the process proceeds from Step S6 to Step S8, and the smart glass 10 cancels the operation. Specifically, the smart glass 10 deletes the text of the operation instruction obtained by the voice recognition once, and the command is not transmitted from the smart glass 10 to the substrate processing apparatus 40. Accordingly, the portion of the substrate processing apparatus 40 does not perform the operation.

In the first embodiment, the smart glass 10 receives the operation instruction by the voice emitted from the worker wearing the smart glass 10, converts the operation instruction into the text by the voice recognition, and displays the text. The worker visually confirms the displayed text, and expresses that the confirmation result is accepted by a hand gesture when the contents thereof are correct. The smart glass 10 takes the image of the gesture of the worker and analyzes the gesture, and transmits the command of the operation instruction to the substrate processing apparatus 40 only when the confirmation result is accepted.

Since the smart glass 10 displays the contents of the received voice converted into the text by the voice recognition and the worker confirms the contents, prevented is supply of the operation instruction by the wrong voice recognition to the substrate processing apparatus 40. Thus, even when the smart glass 10 wrongly translates the operation instruction by the voice emitted from the worker, the erroneous operation of the substrate processing apparatus 40 along the wrong translation contents can be prevented.

A plurality of workers may perform a maintenance operation at the same time on the plurality of processing units 50 mounted to the substrate processing apparatus 40. In such a case, there is a possibility that the smart glass 10 receives voice emitted from a worker different from the worker wearing the smart glass 10 and converts the voice into the text. In the first embodiment, the smart glass 10 displays the contents converted into the text and the worker confirms the contents. Thus, even when the smart glass 10 receives the voice emitted from the other person and converts the voice into the text, the worker recognizes wrong contents and can prevent execution of the operation instruction by the different person. Thus, an erroneous operation of the substrate processing apparatus 40 by the voice emitted from the different person can be prevented. That is to say, according to the first embodiment, the erroneous operation of the substrate processing apparatus 40 by the wrong voice recognition can be prevented, and as a result, safety of the worker can be ensured.

### <Second embodiment>

Next, a second embodiment of the present invention will be described. A whole configuration of a work assistance system and a configuration of the substrate processing apparatus 40 in the second embodiment are the same as those in the first embodiment. A procedure of the work assistance method in the second embodiment is also substantially the same as that in the first embodiment. Although the worker expresses the confirmation result of the contents converted into the text by the hand gesture in the first embodiment, it is determined whether or not the confirmation result is accepted by eye-tracking in the second embodiment.

In the manner similar to the first embodiment, the smart glass 10 receives the operation instruction by the voice emitted from the worker wearing the smart glass 10, converts the operation instruction into the text by the voice recognition, and displays the text. For example, when the worker emits voice of "chuck open", the smart glass 10 converts the voice into the text, and "chuck open" is displayed. In the second embodiment, the worker visually confirms the displayed text of the operation instruction, and moves the visual line to a portion to be operated when the contents thereof are correct. For example, when the contents of the text displayed as "chuck open" are correct, the worker views the spin chuck 57 as the portion to be operated. The visual line tracking part 25 of the smart glass 10 tracks the visual line of the worker to recognize where the visual line is directed, and specifies the portion of the substrate processing apparatus 40 visually recognized by the worker. The portion can be specified by the smart glass 10 by previously registering positional information of each portion of the substrate processing apparatus 40 using a visual positioning system (VPS) function included in the smart glass 10 and using the positional information, for example. In the second embodiment, the visual line tracking part 25 functions as a detection part detecting the confirmation result indicated by the worker and obtaining the confirmation information (the direction of the visual line).

Next, in the second embodiment, the operation analyzing part 36 of the smart glass 10 determines whether or not the confirmation result is accepted based on the direction of the visual line of the worker. Specifically, the operation analyzing part 36 analyzes whether or not a target portion as a target of the displayed text of the operation instruction and a portion visually recognized by the worker coincide with each other, and when they coincide with each other, the operation analyzing part 36 determines that the confirmation result is accepted (the text is correct). For example, when the target portion of the text of the operation instruction of "chuck open" is the spin chuck 57 and the portion visually recognized by the worker is also the spin chuck 57, they coincide with each other. Thus, the operation analyzing part 36 determines that the confirmation result is accepted. In this case, the communication part 22 of the smart glass 10 transmits the command of the operation instruction to the controller 45 of the substrate processing apparatus 40, and the controller 45 executes the command.

In the meanwhile, when the target portion of the displayed text of the operation instruction and the portion visually recognized by the worker do not coincide with each other, the operation analyzing part 36 determines that the confirmation result is denied (the text is wrong). In this case, the smart glass 10 cancels the operation, and the portion of the substrate processing apparatus 40 is not operated.

In the second embodiment, the smart glass 10 receives the operation instruction by the voice emitted from the worker wearing the smart glass 10, converts the operation instruction into the text by the voice recognition, and displays the text. The worker visually confirms the displayed text, and expresses that the confirmation result is accepted by the direction of the visual line when the contents thereof are correct. The smart glass 10 tracks and analyzes the direction of the visual line of the worker, and transmits the command of the operation instruction to the substrate processing apparatus 40 only when the confirmation result is accepted.

In the manner similar to the first embodiment, since the smart glass 10 displays the contents of the received voice converted into the text by the voice recognition and the worker confirms the contents, prevented is supply of the operation instruction by the wrong voice recognition to the substrate processing apparatus 40. Thus, also according to the second embodiment, the erroneous operation of the substrate processing apparatus 40 by the wrong voice recognition can be prevented.

### <Third embodiment>

Next, a third embodiment of the present invention will be described. A whole configuration of a work assistance system and a configuration of the substrate processing apparatus 40 in the third embodiment are the same as those in the first embodiment. A procedure of the work assistance method in the third embodiment is also substantially the same as that in the first embodiment.

In the third embodiment, when the smart glass 10 receives the voice emitted from the worker and converts the voice into the text by the voice recognition, the smart glass 10 executes a voice recognition process only when a voice print of the received voice coincides with a voice print of the worker which is previously registered. The voice print expresses a result obtained by performing frequency analysis on the voice by a sonagram. Specifically, the voice print of the worker is previously registered in the acoustic model (Fig. 8) used for specifying the phoneme in the voice recognition process, for example. The voice recognition part 31 compares the voice print obtained by performing frequency analysis on the received voice with the voice print previously registered in the acoustic model. Then, only when a difference therebetween is equal to or smaller than a constant threshold value, the voice recognition part 31 converts the received voice determined to be emitted from the worker coinciding with the worker, which is previously registered, into the text by the voice recognition. The remaining processes other than the check by the voice print are the same as those according to the first embodiment.

In the third embodiment, the voice analysis is executed only when the voice print of the voice received by the sound reception part coincides with the voice print which is previously registered. Accordingly, a possibility that the smart glass 10 receives voice emitted from a worker different from the worker wearing the smart glass 10 and converts the voice can be reduced, and execution of the operation instruction by the different person can be prevented more reliably. As a result, according to the third embodiment, the erroneous operation of the substrate processing apparatus 40 by the wrong voice recognition can be prevented more reliably.

### <Fourth embodiment>

Next, a fourth embodiment of the present invention will be described. A whole configuration of a work assistance system and a configuration of the substrate processing apparatus 40 in the fourth embodiment are the same as those in the first embodiment. A procedure of the work assistance method in the fourth embodiment is also substantially the same as that in the first embodiment.

In the fourth embodiment, only a term relating to a maintenance operation on the substrate processing apparatus 40 is registered in the language model (Fig. 8) used when a word is extracted in the voice recognition process. For example, only terms of "inching" relating to teaching on the processing solution nozzle 60 and "chuck" relating to exchange of the spin chuck 57 are registered in the language model. When the language model is used, the voice recognition part 31 specifies only the term relating to the maintenance operation on the substrate processing apparatus 40 as the word. As a result, the voice emitted from the worker at the time of maintenance on the substrate processing apparatus 40 can be precisely converted into the text with high accuracy. The remaining processes other than the registration of only the term relating to the specific operation in the language model are the same as those according to the first embodiment.

Typically, a general-purpose language model used for the voice recognition is made to learn a large amount of words so that the voice can be exchanged to a sentence appropriate for various conditions. In the fourth embodiment, only the term relating to the specific operation on the substrate processing apparatus 40 is registered in the language model. That is to say, although the language model normally registers as many words as possible, the words registered in the language model are consciously dedicated and narrowed down in the fourth embodiment. Accordingly, the operation instruction by the voice emitted from the worker can be converted into the text more precisely and accurately in a limited condition during the maintenance operation on the substrate processing apparatus 40. As a result, the erroneous operation of the substrate processing apparatus 40 by the wrong voice recognition can be prevented more reliably. Since the language model is downsized, processing efficiency of the voice recognition is increased, and the operation instruction can be converted into the text in a shorter time.

### <Modification example>

While the embodiments according to the present invention have been described hereinabove, various modifications of the present invention are possible in addition to those described above without departing from the scope and spirit of the present invention. For example, the gesture of the worker is analyzed in the first embodiment, and the eye-tracking is used in the second embodiment. However, it is also applicable to determine whether or not the confirmation result having contents converted into the text is accepted using both of them. That is to say, it is also applicable to track the direction of the visual line of the worker to determine whether or not the confirmation result is accepted in addition to analysis of the gesture of the worker.

The worker may express whether or not the confirmation result of the displayed text is accepted by a method other than the hand gesture or the visual line. For example, the worker may indicate the confirmation result by a movement of his/her head wearing the smart glass 10. That is to say, any form is applicable as long as the worker indicate the confirmation result using a part of his/her body.

Although in the fourth embodiment, only the term relating to the specific operation is registered in the language model, it is also applicable to prepare a language model dedicated to the operation for each process of the operation. For example, prepared are a first language model in which only a term relating to teaching on the processing solution nozzle 60 is registered, a second language model in which only a term relating to exchange of the spin chuck 57 is registered, and a third language model in which only a term relating to teaching on the arm of the main transport robot 48 is registered. Then, the worker selects the optimal language model in accordance with processes of the maintenance operation to be executed. For example, the worker who is going to exchange the spin chuck 57 selects the second language model described above. It is sufficient that the language model is selected using the smart glass 10, for example. Since the language model is dedicated to the operation to be executed by the worker, the operation instruction by the voice emitted from the worker can be converted into the text more precisely and accurately.

In each embodiment described above, the worker uses the smart glass 10. However, the configuration is not limited thereto, but the worker may use a mobile terminal such as a tablet terminal or a smartphone in place of the smart glass 10. That is to say, it is sufficient to use a mobile terminal including an imaging part and a communication part. When a tablet terminal, for example, is used, the hand of the worker is filled with the tablet terminal; thus, it is preferable to use a wearable terminal such as the smart glass 10.

The substrate processing apparatus 40 is not limited to a substrate washing apparatus. Any apparatus is applicable as long as it performs predetermined processing on a substrate such as a heat processing apparatus, an exposure apparatus, a coating-developing apparatus, a measuring apparatus, or an inspection apparatus. When the substrate processing apparatus 40 is the substrate washing apparatus, a single-type washing apparatus washing a substrate one by one or a batch-type washing apparatus collectively washing a plurality of substrates is applicable.

Furthermore, a target of the work assistance technique relating to the present invention is not limited to the substrate processing apparatus, but any industrial apparatus including an activation part performing some operation is applicable. Examples of such an industrial apparatus include a printing processing apparatus, a film formation apparatus, a medical apparatus, and an appearance inspection apparatus.

### EXPLANATION OF REFERENCE SIGNS

5 information communication network
10 smart glass
21 imaging part
22 communication part
23 display part
24 sound reception part
25 visual line tracking part
31 voice recognition part
36 operation analyzing part
40 substrate processing apparatus
45 controller
48 main transport robot
50 processing unit
56 rotation holder
57 spin chuck
60 processing solution nozzle
63 swing motor
65 spray nozzle
70 server
80 work assistance terminal
W substrate

## Claims

1. A work assistance method in performing a predetermined operation on an industrial apparatus, comprising:
a sound reception step of receiving operation instruction by voice emitted from a worker wearing a mobile terminal including a sound reception part, a display part, an imaging part, and a communication part by the sound reception part;
a voice recognition step of analyzing voice of a worker received by the sound reception part and converting the voice into a text of the operation instruction;
a display step of displaying the text of the operation instruction by the display part;
a detection step of detecting a confirmation result indicated by a worker, who has confirmed the text of the operation instruction displayed by the display part, using a part of a body of the worker and obtaining confirmation information;
an operation analyzing step of generating instruction information of the operation instruction when the confirmation information is analyzed and the confirmation result is accepted; and
a transmission step of transmitting the instruction information of the operation instruction to the industrial apparatus by the communication part.

2. The work assistance method according to claim 1, wherein
in the detection step, the imaging part takes an image of a gesture of a worker.

3. The work assistance method according to claim 1, wherein
the mobile terminal further includes a visual line tracking part tracking a visual line of a worker wearing the mobile terminal,
in the detection step, a portion of the industrial apparatus visually recognized by a worker is specified by the visual line tracking part, and
in the operation analyzing step, it is determined that the confirmation result is accepted when a target portion as a target of the text of the operation instruction coincides with a portion visually recognized by a worker.

4. The work assistance method according to claim 1, wherein
in the voice recognition step, voice analysis is executed only when a voice print of voice received by the sound reception part coincides with a voice print which is previously registered.

5. The work assistance method according to claim 1, wherein
the voice recognition step includes:
a phoneme specification step of specifying a phoneme included in voice of a worker received by the sound reception part using an acoustic model; and
a word conversion step of converting an arrangement of the phoneme specified in the phoneme specification step into a word using a language model, and
only a term relating to a specific operation on the industrial apparatus is registered in the language model.

6. The work assistance method according to claim 1, wherein
the industrial apparatus is a substrate processing apparatus performing predetermined processing on a substrate.

7. The work assistance method according to any one of claims 1 to 6, wherein
the mobile terminal is a smart glass.

8. A work assistance system in performing a predetermined operation on an industrial apparatus using a mobile terminal, wherein
the mobile terminal includes:
a sound reception part receiving operation instruction by voice emitted from a worker wearing the mobile terminal;
a voice recognition part analyzing voice of a worker received by the sound reception part and converting the voice into a text of the operation instruction;
a display part displaying the text of the operation instruction;
a detection part detecting a confirmation result indicated by a worker, who has confirmed the text of the operation instruction displayed on the display, using a part of a body of the worker and obtaining confirmation information;
an operation analyzing part analyzing the confirmation information and generating instruction information of the operation instruction when the confirmation result is accepted; and
a communication part transmitting the instruction information of the operation instruction to the industrial apparatus.

9. The work assistance system according to claim 8, wherein
the detection part includes an imaging part taking an image of a gesture of a worker.

10. The work assistance system according to claim 8, wherein
the detection part includes a visual line tracking part tracking a visual line of a worker wearing the mobile terminal and specifying a portion of the industrial apparatus visually recognized by a worker, and
the operation analyzing part determines that the confirmation result is accepted when a target portion as a target of the text of the operation instruction coincides with a portion visually recognized by a worker.

11. The work assistance system according to claim 8, wherein
the voice recognition part executes voice analysis only when a voice print of voice received by the sound reception part coincides with a voice print which is previously registered.

12. The work assistance system according to claim 8, wherein
wherein the voice recognition part specifies a phoneme included in voice of a worker received by the sound reception part using an acoustic model and converts an arrangement of the phoneme which has been specified into a word using a language model, and
only a term relating to a specific operation on the industrial apparatus is registered in the language model.

13. The work assistance system according to claim 8, wherein
the industrial apparatus is a substrate processing apparatus performing predetermined processing on a substrate.

14. The work assistance system according to any one of claims 8 to 13, wherein
the mobile terminal is a smart glass.
